# EUROPEAN PATENT SPECIFICATION

(11) **EP 0 502 562 B1**
(45) Date of publication and mention of the grant of the patent: **06.05.1998**
(21) Application number: 92200424.7
(22) Date of filing: 14.02.1992
(51) Int. Cl.: G03F 7/027

(54) **Method for producing images**
Verfahren zur Herstellung von Bildern
Méthode pour la production d'images

(30) Priority: 05.03.1991 EP 91200468
(43) Date of publication of application: 09.09.1992
(73) Proprietor: AGFA-GEVAERT N.V., 2640 Mortsel (BE)
(72) Inventor: Uytterhoeven, Herman Jozef, B-2820 Bonheiden (BE); Podszun, Wolfgang, W-5000 Köln (DE); Müller, Michael, W-5060 Bergisch Gladbach 2 (DE); Vermeersch, Joan Triphin, B-9800 Deinze (BE); Voortmans, Gilbert Johannes, B-2340 Beerse (BE)

(56) References cited:
- EP-A- 0 352 055
- EP-A- 0 355 387
- DE-A- 3 643 216
- DE-A- 3 703 080
- DE-A- 3 703 130
- DE-A- 3 917 320
- PATENT ABSTRACTS OF JAPAN vol. 15, no. 92 (C-811)(4620) 6 March 1991; & JP-A-2 306 955

## Description

### 1. Field of the invention.

The present invention relates to the formation of images by means of photopolymerization. More particularly the present invention relates to a method for producing multiple copies of an image.

### 2. Background of the invention.

The use of photopolymerizable compositions for the production of images by information-wise exposure thereof to actinic radiation is well known. Several methods for forming images using photopolymerizable compositions are known. All these methods are based on the principle of introducing a differentiation in properties between the exposed and non-exposed parts of the photopolymerizable composition e.g. a difference in solubility, adhesion, conductivity, refractive index, tackiness, permeability, diffusibility of incorporated substances e.g. dyes etc.. The thus produced differences may be subsequently employed in a developing step to produce a visible image and/or master for printing e.g. a lithographic or electrostatic printing master.

A difference in solubility between the exposed and non-exposed parts of the photopolymerizable composition is often used for the production of lithographic printing plates where a hydrophilic base is coated with the photopolymerizable composition, subsequently exposed and developed using a solvent to remove the non-exposed or insufficiently exposed parts. Such a process is for example described in "Unconventional imaging processes" by E. Brinckman, G. Delzenne, A. Poot and J. Willems, Focal Press London-New York, first edition 1978, pages 33 to 39.

The use of the difference in tackiness to obtain an image is described in e.g. US-P 3,060,024, 3,085,488 and 3,649,268. According to the method disclosed in these US patent applications the image-wise exposed photopolymerizable composition looses its tackiness in the exposed parts while the non-exposed parts keep their tackiness. The non-exposed parts can therefore be colored with dry dye pigments to make the image visible.

According to the methods described in e.g. US-P 3,245,796 and EP-A 362,827 the diffusibility of a dye is impeded in the photo-exposed parts of the photopolymerizable composition so that during an overall thermal heating subsequent to photo-exposure dye substances in the non-exposed areas will be able to diffuse to a receptor material. According to a similar method described in US-P 4,587,198 the photopolymerizable composition is made impermeable in the exposed parts for a sublimable dye or dye-pigment present in a layer adjacent to the layer comprising the photopolymerizable composition.

According to a method disclosed in US-P-3,060,023 the adhesion of the photopolymerizable composition is modified upon image-wise exposure. After image-wise exposure the non-exposed parts will stick or adhere, during a step of overall heating, to a receiving sheet thus allowing the transfer of the non-exposed parts to the receiving sheet.

As illustrated above photopolymerization can be used in a variety of methods to reproduce images. Among these methods several are using dry-developing steps for producing the image which is convenient and offers an ecological advantage. However the sensitivity of most photopolymerizable compositions is rather low so that they are e.g. not suitable for use in exposure with laser light sources which are recently widely employed for reproducing images.

### 3. Summary of the invention.

It is an object of the present invention to provide a method for reproducing images in a convenient and ecological way using a photopolymerizable composition of high sensitivity.

It is a further object of the present invention to provide a method for producing a lithographic printing plate in a convenient and ecological way using a photopolymerizable composition of high sensitivity.

Further objects of the present invention will become clear from the description hereinafter.

According to the present invention a method is provided for making an image as set out in claim 1. The photopolymerizable composition shows a high polymerization rate and solidification at low conversion.

According to the present invention there is also provided a method for producing a lithographic printing plate as set out in claim 5. The photopolymerizable composition shows a high polymerization rate and solidification at low conversion.

According to the present invention there is also provided an imaging element as et out in claim 8.

### 4. Detailed description of the invention

The multi-functional (met)acrylate monomers for use in accordance with the present invention correspond to general formula (I):

A[-NHCO-X-L₁(-(L₂)ᵤ-OCO-CR₁=CH₂)ₙ]ₘ (I)

wherein n represents an integer from 1 to 3, m equals an integer of 3 to 6 when n equals 1 and 2 to 6 when n equals 2 or 3 and u equals 0 or 1;
A represents an organic group of the following nature being 3 to 6 valent when n equals 1 and being 2 to 6 valent when n equals 2 or 3 :
   a) a hydro carbon residue containing 5 to 25 carbon atoms which may be interrupted by one or more ether, ester or amide functions.
   b) 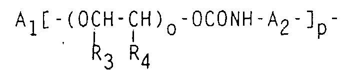 with A₁ representing a linear or branched aliphatic residue that may contain 0 to 3 0-atoms and 2 to 20 C-atoms, an aromatic residue containing 6 to 24 carbon atoms, an aromatic aliphatic residue containing 7 to 28 C-atoms or an cycloaliphatic residue containing 6 to 26 C-atoms, R₃ and R₄ each independently representing a hydrogen or a methyl group, A₂ representing a hydro carbon residue containing 5 to 25 carbon atoms, o represents an integer of 0 to 5 and p represents an integer of 2 to 6 when n equals 2 or 3 and represents an integer of 3 to 6 when n equals 1
   c) 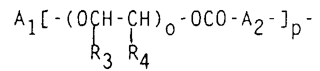 wherein A₁, A₂, R₃, R₄, o and p have the same meaning as defined above
   d) 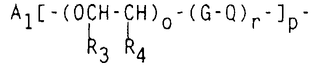 wherein A₁, A₂, R₃, R₄, o and p have the same meaning as defined above
      G represents -O-CO-NH-Y(-COO-)_{q}-
         wherein Y represents a divalent (cyclo)aliphatic residue containing 2 to 15 C-atoms and that may contain an ester, ether or urethane function and q represents 0 or 1
      Q represents a linear or branched aliphatic hydro carbon residue containing 3 to 15 carbon atoms and which may comprise 1 to 3 oxygen bridges and r equals 0 or 1,
X represents 0 or NR₂,
L₁ represents an aliphatic hydro carbon residue that is at least di-valent and that may comprise 1 to 3 O-atoms,
L₂ represents a lower alkylene of 1 to 6 C-atoms which may be branched or linear,
R₁ represents hydrogen or a methyl group,
R₂ represents hydrogen or a lower alkyl group of 1 to 6 C-atoms,

Preferably used monomers comprise one of the following residues as hydro carbon residue A of general formula (I): 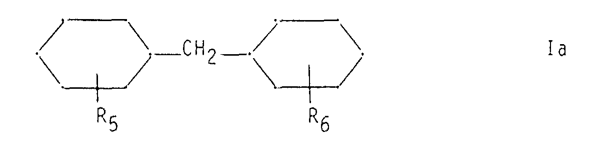 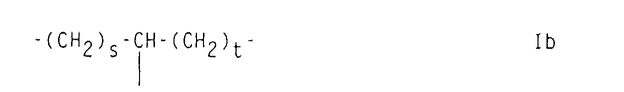 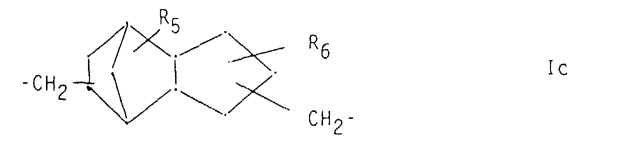 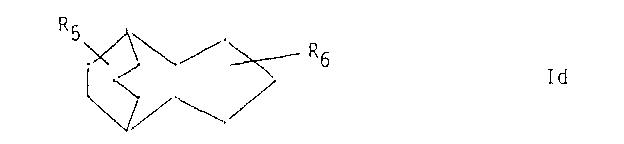 wherein R₅ and R₆ each independently represents hydrogen or a lower alkyl of 1 to 6 C-atoms, s and t independently represent an integer from 1 to 6 and wherein the aliphatic hydro carbon residues Ia, Ic and Id comprise 2 to 6 free valences.

Examples of monomers suitable for use in accordance with the method of the present invention are shown in table 1.

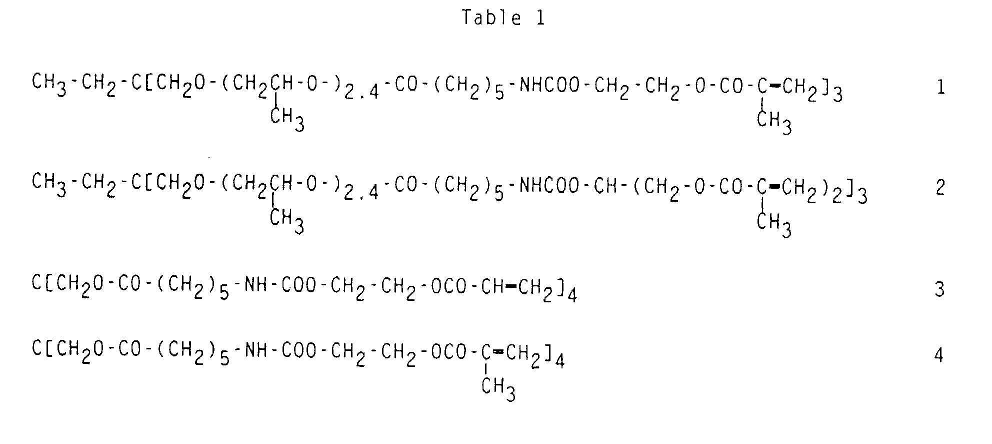

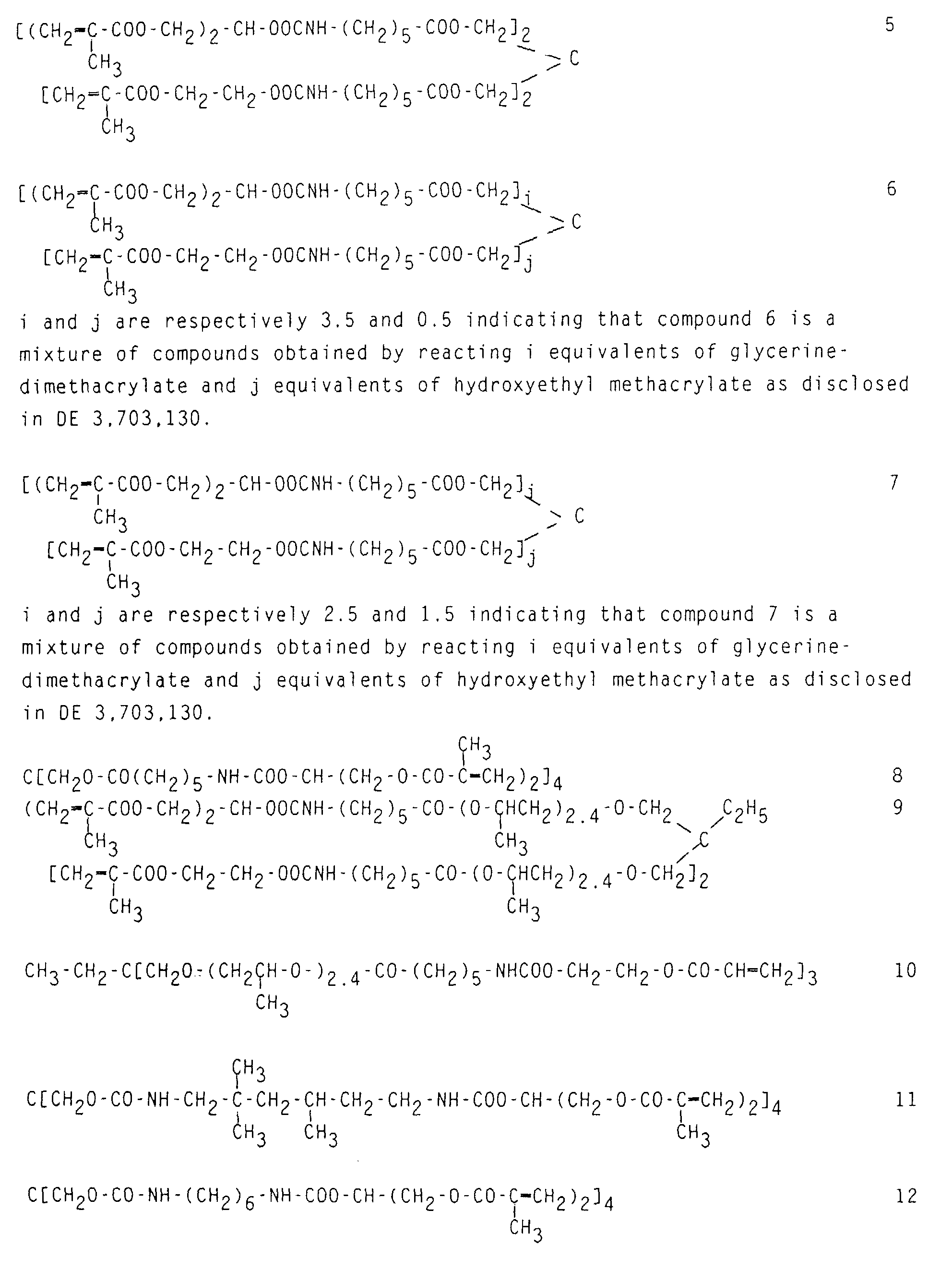

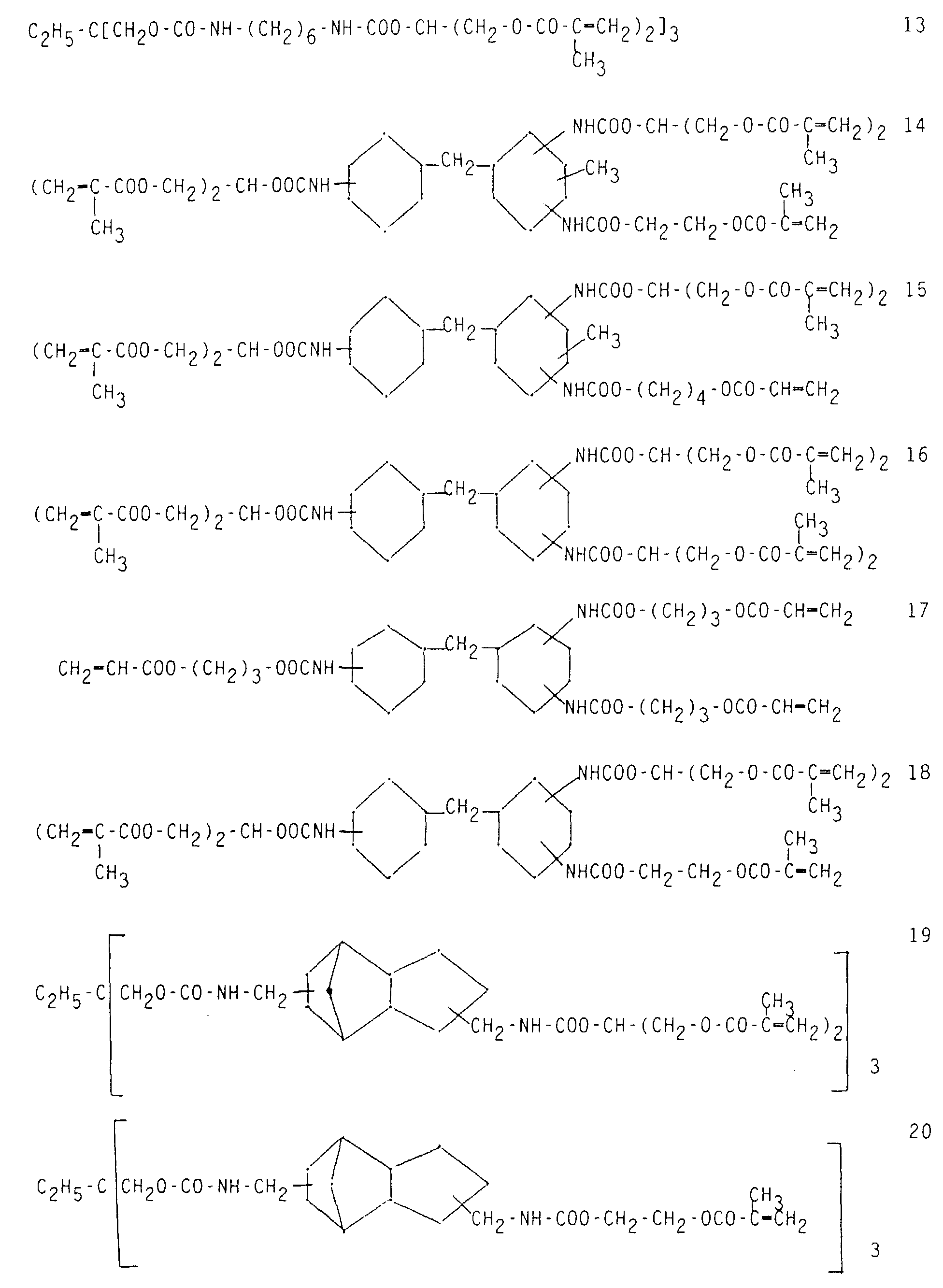

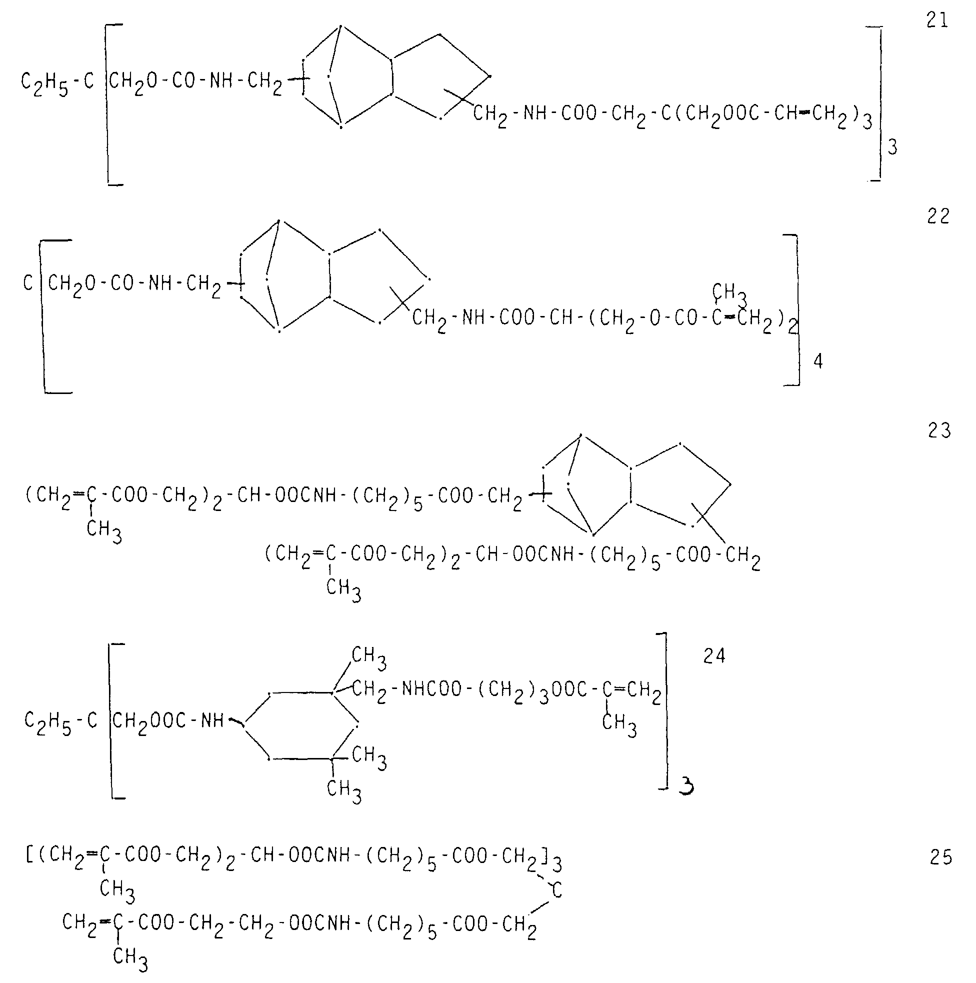

The fractal indexes in the formulas 1, 2 and 10 indicate that these formulas represent a mixture of compounds having a different length of the ethylene-oxide piece in said formulas the indexes thus representing an avarage of said ethylene-oxide piece. The formulas 14 to 23 represent a mixture of structural isomers and can be used in accordance with the present invention without separation of the isomers.

It has been found that the monomers corresponding to general formula (I) show a high polymerization rate and solidify even at conversions of as low as 10% thus allowing a rapid differentiation between exposed and non-exposed parts. The monomers corresponding to general formula (I) are known and can be prepared according to the methods disclosed in the German patent applications numbers 3,522,005, 3,703,080, 3,643,216, 3,703,130, 3,703,080, 3,917,320 and 3,743,728.

The photopolymerizable composition is exposed to an information-wise distribution of actinic radiation to harden said photopolymerizable composition pattern-wise in correspondence to said information-wise distribution of actinic radiation. The exposure can be a contact exposure using e.g ultraviolet radiation, a camera exposure, a scanning exposure, or a laser exposure. The radiation source used in carrying out the exposure step includes e.g. sunlight, incandescent lamps, mercury vapour lamps, halogen lamps, xenon lamps, fluorescent lamps, light-emitting diodes, lasers, electron rays, and X-rays.

According to the present invention the monomers corresponding to general formula (I) are comprised in a thermoplastic layer comprising a thermoplastic polymer coated on the support of an imaging element. After image-wise exposure the thermoplastic layer is heated and brought in contact with a receiving material. Said heating may be applied to either or both the imaging element or receiving material while or before bringing both materials in contact with each other.

Said thermoplastic layer is preferably solid at temperatures below 40°C and is transferable in the non-exposed or insufficiently exposed parts at temperatures between 40°C and 250°C.

Suitable thermoplastic polymers for use in accordance with the present invention include :
(A) Copolyesters, e.g. those prepared from the reaction product of an alkylene glycol e.g. polymethylene glycol of the formula HO(CH₂)ᵥOH, wherein v is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids.
(B) Nylons or polyamides, e.g. N-methoxymethyl polyhexamethylene adipamide;
(C) Vinylidene chloride copolymers, e.g. vinylidene chloride/acrylonitrile; vinylidene chloride/methylacrylate and vinylidene chloride/vinylacetate copolymers;
(D) Ethylene/vinyl acetate copolymer;
(E) Cellulosic ethers, e.g. methyl cellulose, ethyl cellulose and benzyl cellulose;
(F) Polyethylene;
(G) Synthetic rubbers, e.g. butadiene/acrylonitrile copolymers, and chloro-2-butadiene-1,3 polymers;
(H) Cellulose esters, e.g. cellulose acetate, cellulose acetate succinate and cellulose acetate butyrate, cellulose nitrate;
(I) Polyvinyl esters, e.g. polyvinyl acetate/acrylate, polyvinyl acetate/methacrylate and polyvinyl acetate;
(J) Polyacrylate and alpha-alkyl polyacrylate esters, e.g. polymethyl methacrylate and polyvinyl acetate;
(K) High molecular weight polyethylene oxides of polyglycols having average molecular weights from about 4,000 to 1,000,000;
(L) Polyvinyl chloride and copolymers, e.g. polyvinyl chloride/acetate, polyvinylchloride/acetate/alkohol;
(M) Polyvinyl acetal, e.g. polyvinyl butyral, polyvinyl formal;
(N) Polyformaldehydes;
(O) Polyurethanes and copolymers;
(P) Polycarbonate and copolymers;
(Q) Polystyrenes and copolymers e.g. polystyrene/acrylonitrile, polystyrene/acrylonitrile/butadiene.

To the thermoplastic polymer constituent of the photopolymerizable composition there can be added non-thermoplastic polymeric compounds to give certain desirable characteristics, e.g. to improve adhesion to the base support, adhesion to the receptor support on transfer, wear properties chemical inertness, Suitable non-thermoplastic polymeric compounds include polyvinyl alcohol, cellulose, anhydrous gelatin, phenolic resins and melamine-formaldehyde resins. If desired, the photopolymerizable layers can also contain immiscible polymeric or non-polymeric organic or inorganic fillers or reinforcing agents which are essentially transparent at the wave-lengths used for the exposure of the photopolymeric material, e.g. the organophilic silicas, bentonites, silica, powdered glass, colloidal carbon, as well as various types of dyes and pigments in amounts varying with the desired properties of the photopolymerizable layer. The fillers are useful in improving the strength of the composition, reducing tack and in addition, as coloring agents.

Agents to improve the wetting and/or adjust the adhesion of the thermoplastic layer may be added. Suitable agents are e.g. silicons, silicon containing polymers e.g. a poly(dimethylsiloxane)-polyether copolymer, poly(dimethylsiloxane)-polyester, silicon containing surfactants, fluor containing copolymers and fluor containing surfactants.

The monomers corresponding to general formula (I) may be mixed with other polymerizable ethylenically unsaturated compounds. Suitable polymerizable ethylenically unsaturated compounds which can be used in accordance with the present invention are e.g. unsaturated esters of polyols. particularly such esters of the alpha-methylene carboxylic acids, e.g. ethylene diacrylate, glycerol tri(meth)acrylate, ethylene dimethacrylate, 1,3-propanediol di(meth)acrylate 1,2,4-butanetriol tri(meth)acrylate, 1,4-cyclohexanediol di(meth)acrylate, 1,4-benzenediol di(meth)acrylate, pentaerythritol tetra(meth)acrylate, 1,5-pentanediol di(meth)acrylate, the bis acrylates and methacrylates of polyethylene glycols of molecular weight 200-500, and the like : unsaturated amides, (particularly those of the alphamethylene carboxylic acids, and especially those of alpha-omega-diamines and oxygen-interrupted omega-diamines, such as methylene bis-acrylamide, methylene bis-methacrylamide, 1,6-hexamethylene bis-acrylamide, diethylene triamine tris-methacrylamide, bis(gamma-methacrylamidopropoxy)ethane, beta-methacrylamidoethyl methacrylate, N-(beta-hydroxyethyl)-beta-(methacrylamido)ethyl acrylate and N,N-bis(beta-methacrylolyoxyethyl)acrylamide; vinyl esters e.g. divinyl succinate, divinyl adipate, divinyl phthalate, divinyl butane-1,4-disulfonate; and unsaturated aldehydes, e.g. sorbaldehyde (hexadienal). Other suitable polymerizable ethylenic unsaturated compounds that can be used in accordance with the present invention are polymers and/or oligomers comprising 2 or more polymerizable functions e.g. acrylated epoxies, polyester acrylates, urethane acrylates.

The amount of monomers corresponding to general formula (I) and optionally comonomers as described above added varies with the particular thermoplastic polymer and/or other additives used.

The photopolymerizable composition used in accordance with the present invention also comprises at least one photoinitiator. Preferably used photoinitiators are polymerization initiators activatable by actinic light and thermally inactive at and below 185°C. Examples of such initiators include the substituted or unsubstituted polynuclear quinones which are compounds having two intracyclic carbonyl groups attached to intracylic carbon atoms in a conjugated six-membered carbocyclic ring, there being at least one aromatic carbocyclic ring fused to the ring containing the carbonyl groups. Such initiators include 9-10-anthraquinone, 1-chloroanthraquinone, 2-chloroanthraquinone, 2-methylanthraquinone, 2-tert-butylanthraquinone, octamethylanthraquinone, 1,4-naphtoquinone, 9,10-phenanthrenequinone, 1-2 benzanthraquinone, 2,3-dichloronaphthoquinone, sodium salt of anthraquinone alpha-sulfonic acid, 3-chloro-2-methylanthraquinone, and 1,2,3,4-tetrahydrobenzene a anthracene-7,12-dione. The photointiators which are also useful are described in Plambeck U.S. Patent 2,760,863 and include vicinal ketaldonyl compounds, such as diacetyl, benzil, alpha-ketaldonyl alcohols, such as benzoin, pivalon, acyloin ethers e.g. benzoin methyl and ethyl ethers, ; alpha-hydrocarbon substituted aromatic acyloins, including mehtylbenzoin, alpha-allylbenzoin, and alpha-phenylbenzoin. Still further photoinitiators useful in accordance with the present invention are those disclosed in "Photoreactive Polymers" by Arnost Reiser, "Organic photochemical imaging systems" by G.A. Delzenne, in the paper "UV-Curing Chemistry: Past, Present, and Future" by Christian Decker, published in J. of Coatings Technology, Vol.59,N° 751, August 1987, pages 97-106, in EP-A 362,827, and in US-A 3,558,309.

According to the present invention thermal polymerization inhibitors may also be added to the photopolymerizable composition. Inhibitors for use in accordance with the present invention are p-methoxyphenol, hydroquinone, lakyl and acyl-substituted hydroquinones and quinones, tert-butylcatechol, pyrogallol, copper resinate, naphtylamines, beta-naphtol, cuprous cloride, 2,6-di-tert-butyl p-cresol, photothiazine, pyridine, nitrobenzene and dinitrobenzene, p-toluquinone and chloranil.

Various dyes, pigments, thermographic compounds, UV-absorbers, antioxidants and color forming components can be added to the photopolymerizable compositions to give a variety of results after the thermal transfer. These additive materials, however, preferably should not absorb excessive amounts of light at the exposure wavelength or inhibit the polymerization reaction.

Among the dyes useful in the invention are Fuchsine (C.I. 42510), Auramine Base (C.I. 410003), Calcocid Green S (C.I. 44000), Para Magenta (C.I. 42500), Tryparosan (C.I. 42505), New Magenta (C.I. 42520), Acid Violet RRL (C.I. 42425), Red Violet 5RS (C.I. 42960), C.I. Solvent Blue 36 (C.I. 61551), Nile Blue 2B (C.I. 51185), New Methylene BLue GG (C.I. 51195), C.I. Basic Blue 20 (C.I. 42585, Iodine Green (C.I. 42556), Night Green B (C.I. 42415), C.I. Direct Yellow 9 (C.I. 19540), C.I. Acid Yellow 17 (C.I. 18965), C.I. Acid Yellow 29 (C.I. 18900), Tartrazine (C.I. 19140), Supramine Yellow G (C.I. 19300), Buffalo Black 10B (C.I. 27790), Naphtalene Black 12R (C.I. 20350), Fast Black L (C.I. 51215), and Ethyl Violet (C.I. 42600).

Suitable pigments include, e.g. TiO₂, colloidal carbon, graphite, phosphor particles, ceramics, clays, metal powder such as aluminium, copper, magnetic iron and bronze. The pigments are useful when placed in the photosensitive layer or in an adjacent non-photosensitive layer e.g. an anti-halation layer or (a) layers improving the adherence between the support and the photosensitive layer.

Useful thermographic additives, e.g. 3 cyano-4,5-dimethyl-5-hydroxy-3-pyrrolin-2-one, and activators, e.g. copper acetate, are disclosed in the application of Holland and Wayrynen, Ser. No.807,761, filed April 21, 1959, and the following U.S. Patents : 2,825,494, 2,637,657, 2,665,654, 2,663,655, 2,663,656, and 2,663,657.

Suitable color-forming components which form colored compounds on the appplication of heat or when brought in contact with other color forming components in a receptor material are e.g.:
(1) Organic and inorganic components : dimethyl glyoxime and nickel salts; phenolphtalein and sodium hydroxide; starch/potassium iodide and oxidizing agent, i.e. peroxides, phenols and iron salts; thioacetamide and lead acetate, silver salt and reducing agent, e.g. hydroquinone.
(2) Inorganic components : ferric salts and potassium thiocyanate; ferrous salts and potassium ferricyanide; copper or silver salts and sulfide ions; lead acetate and sodium sulfide.
(3) Organic components : 2,4-dinitrophenylhydrazine and aldehydes or ketones; diazonium salt and phenol or naphtol, e.g. benzenediazonium chloride and B-naphtol; p-dimethylaminobenzaldehyde and p-diethylaminoaniline.

Suitable supports of the imaging element for use in accordance with the present invention are supports that are stable at the heating temperatures necessary for transfering the non-exposed or insufficiently exposed parts of the photopolymerizable composition to the receiving material. Examples of useful supports are e.g. polyester film supports e.g. polyethylene terephthalate, glass, wood, paper, polyethylene coated paper, cellulose esters e.g. cellulose acetate, cellulose propionate, cellulose butyrate, poly carbonate, polyvinyl chloride, polyimide, polypropylene.

The receiving material to which the image is transferred must also be stable at the process temperature. The particular material used is dependent on the adhesion of the image to the support of the imaging element. Suitable receiving materials include paper, cardboard, metal sheets foils and meshes e.g. aluminium, copper, steel, bronze etc., polyethylene, polyester film supports e.g. polyethylene terephthalate, opaque foamed or pigmented polyester, cellulose esters, silk, cotton, viscose rayon fabrics or screens, polycarbonate, polyvinyl chloride, polypropylene, polyethylene coated paper.

The surface of the receiving material may be a hydrophilic surface, a layer showing preferential adhesion towards the non-exposed parts of the layer containing the photopolymerizable composition or contain on its surface compounds that react with compounds being transferred so as to produce difference in color, hydrophilicity or conductivity at the surface of the receiving material corresponding to the exposed and non-exposed parts.

The imaging element and receiving material may also be brought in contact before exposure or may be present in one element. Such an element is called a monosheet material and requires that either its back or its front is transparant for the radiation used for the exposure of the photopolymerizable composition.

In an especially preferred embodiment of the present invention the receiving material contains a hydrophilic surface. Transfer of the non-exposed or insufficiently exposed parts of the photopolymerizable composition to a receiving material having a hydrophilic surface will thus result in an image-wise differentiation between hydrophilic and hydrophobic parts that can be used to print with an oily or greasy ink. The hydrophobic parts will be capable of accepting lithographic ink, whereas the hydrophilic areas, when moistened with water, will not accept the ink. The areas which accept ink form the printing image areas and the ink-rejecting areas form the background areas.

After transfer of the non-exposed or insufficiently exposed parts of the photopolymerizable composition to the receiving material it may be advantageous to overall expose the transferred image to light and/or heat to enhance the stability of the transferred image. Such a procedure is especially preferably when the transferred image is used as a printing master as described above.

Receiving materials having a hydrophilic surface are e.g. metal supports like Al or Zn, polyester film supports and paper bases. These supports, if not sufficient hydrophilic by themselves, are first coated with a hydrophilic layer. A particularly suitable hydrophilic layer is a layer of polyvinyl alcohol hardened with a tetraalkyl orthosilicate e.g. tetramethylorthosilicate or tetraethylorthosilicate containing TiO₂ as disclosed in e.g. US-P-3971660.

A preferably used metal support is aluminium. Suitable aluminium supports for use in accordance with the present invention are aluminium foils made of pure aluminium or of an aluminium alloy, the aluminium content of which is at least 95%. A useful alloy is e.g. one comprising 99.55% by weight of Al, 0.29% of Fe, 0.10% of Si, 0.004% of Cu, 0.002% of Mn, 0.02% of Ti, and 0.03% of Zn. The thickness of the foil usually ranges from about 0.13 to about 0.50 mm.

The preparation of aluminium or aluminium alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results.

Graining of the aluminium surface can be carried out mechanically or electrolytically in any known way. The roughness produced by the graining is measured as a centre line average value expressed in µm and preferably varies from about 0.2 to about 1.5 µm.

The anodization of the aluminium foil can be performed in electrolytes e.g. chromic acid, oxalic acid, sodium carbonate, sodium hydroxide, and mixtures thereof. Preferably, the anodization of the aluminium is performed in dilute aqueous sulphuric acid medium until the desired thickness of the anodization layer is reached. The aluminium foil may be anodized on both sides. The thickness of the anodization layer is most accurately measured by making a micrographic cut but can be determined likewise by dissolving the anodized layer and weighing the plate before dissolution treatment and subsequent thereto. Good results are obtained with an anodization layer thickness of about 0.4 to about 2.0 µm. To promote the image sharpness and, as a consequence thereof, the sharpness of the final printed copy, the anodization layer may be coloured in the mass with an antihalation dye or pigment e.g. as described in JA-A 58-14797. The dye or pigment or a combination of dyes or pigments used for such colouring in the mass are chosen such that they prevent or reduce halation in the layer comprising the polymer containing aryldiazosulfonates.

After the anodizing step the anodic surface may be sealed. Sealing of the pores of the aluminium oxide layer formed by anodization is a technique known to those skilled in the art of aluminium anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminium surface exist. An advantageous sealing method is the hydration-sealing method, according to which the pores are closed or partially closed through water-acceptance so that hydrated needle-like aluminium oxide crystals (böhmite) are formed. The anodic surface of the aluminium foil can thus be rinsed with water at 70-100°C or with steam. The hot sealing water may comprise additives e.g. nickel salts to improve the sealing effect. The sealing can also be performed by treatment of the anodic surface with an aqueous solution comprising phosphate ions or silicates. Thanks to the sealing treatment the anodic layer is rendered substantially non-porous so that longer press runs can be made with the printing plate obtained. As a result of the sealing the occurrence of fog in the non-printing areas of the printing plate is avoided substantially.

The graining, anodizing, and sealing of the aluminium foil can be performed as described in e.g. US-A 3,861,917 and in the documents referred to therein.

The method of the present invention can also be employed for producing an electrostatic printing master. According to this mode the image-wise exposed photopolymerizable composition used in accordance with the present invention is transferred to a receiving material having a conductive surface or a surface containing compounds that react with compounds being transferred so as to produce an image-wise differentiation in conductivity. Preferably a receiving material carrying a conductive surface e.g. a polyethylene terephthalate support provided with a metallic layer of e.g. aluminium is used. After the transfer of the image-wise exposed photopolymerizable composition to such a material the parts where no transfer took place, corresponding to the exposed parts of the photopolymerizable composition contained in the imaging element, remain conductive while the other parts have become non-conductive. An electrostatic printing master can thus be obtained.

The receiving material may be a support provided with a metal layer e.g. copper. A printed circuit can thus be produced in a subsequent etch treatment where the image-wise transferred photopolymerizable composition serves as a resist.

According to another mode of the present invention color images can be prepared. According to this mode at least three imaging elements comprising respectively a yellow, magenta and cyan dye or dye pigment in or underneath a photopolymerizable composition used in accordance with the present invention, are image-wise exposed with respectively the blue, green and red color selection of the image. Optionally a fourth imaging element comprising a black dye or dye pigment can be used. Each of these imaging elements is successively heated in contact with the same receiving material e.g. a paper material to allow the transfer of each of the different color selections of the image. It is obvious that the transfer of the different color parts of the image must be carried out in register to obtain a faithful reproduction of the original image.

An image can also be prepared by heating an image-wise exposed imaging element comprising the photopolymerizable composition used in accordance with the present invention as an outermost layer to a temperature sufficient for obtaining the non-exposed or insufficiently exposed parts tacky while the exposed areas due to photopolymerization do not become tacky. In a subsequent powdering with a dye pigment e.g. carbon black the image can be developed since said dye pigment will stick to the tacky parts of the heated imaging element. After cooling the powdered imaging element to room temperature the imaging element is advantageous overall exposed to harden the powdered parts. An image of good quality and high contrast can be obtained.

The above described modes of the present invention are the most preferred modes of the present invention because they offer the advantage of being convenient and ecological due to the dry development step used. However it will be clear to a person skilled in the art that the photo-exposed photopolymerizable composition may also be developed using suitable solvents to dissolve the photosensitive layer in the non-exposed or insufficiently exposed parts. Suitable solvents for use in such a development process are organic solvents e.g. chloroform, dichloroethane, dichloromethane, toluene, benzene. Since organic solvents, which are often highly toxic, have to be used in this development process the process has an ecological disadvantage and is less convenient than the above described modes of the present invention. However this process is still advantageous over known processes employing photopolymerizable composition because the method of the present invention makes use of a photopolymerizable composition having a high polymerization rate and showing rapid solidification.

The following examples illustrate the present invention without limiting it thereto. The percentages given are by weight unless otherwise stated.

### EXAMPLE 1

### Preparation of imaging elements.

Subbed polyethylene terephtalate supports having a thickness of 100 pm were coated by means of a knife coater with an organic photochemical imaging composition consisting of a solution in methyl-ethyl keton of 3.5% by weight of a compound listed in table 1. 0.5% by weight of co(styrene-acrylonitrile) comprising 104 styrene units and 53 acrylonitrile units, which copolymer is sold under the trade mark LURAN 378 P by BASF AG, D-6700 Ludwigshafen, Germany, 0.25% by weight of a blue dye (C.I. 61551), 0.02 % by weight of a polysiloxane polyether copolymer sold under the trade mark TEGOGLIDE 410 by TH. GOLDSCHMIDT AG, D-4300 Essen 1, Goldschmidtstrasse 100, Germany, 3.5% by weight of bis-imidazole, 0.1% by weight of Michler's ketone, and 0.2% by weight of mercaptobenzoxazole. The mixture was coated to form a layer having a thickness in wet condition of 50 µm. The resulting layer was dried.

### Preparation of a receiving element

To 418 g of a dispersion containing 21.5 % of TiO₂ (average particle size 0.3 to 0.5 µm) and 2.5 % of polyvinyl alcohol in deionized water were subsequently added, while stirring, 220 g of a 5 % polyvinyl alcohol solution in water, 95 g of a hydrolyzed 22 % tetramethyl orthosilicate emulsion in water and 22 g of a 10 % solution of a wetting agent. To this mixture was then added 245 ml of deionized water and the pH was adjusted to pH=4.

The resulting dispersion was coated on a polyester (coated with a hydrophilic adhesion layer) support to a wet coating thickness of 55 g/m² and dried at 30 °C.

### Preparation of lithographic printing plates

The imaging elements described above were placed in contact with a test target and exposed therethrough to ultraviolet radiation.

Each of the exposed imaging elements was then placed in face-to-face contact with a hydrophilic receiving element prepared as described above.

The contacting elements were conveyed through a roll laminator device at about 186°C and a speed of 0.63 m/min. Next, the elements were peeled apart.

The thus obtained printing plates could be used to print on a conventional offset press using a commonly employed ink and fountain. Good copies were obtained.

### EXAMPLE 2

Imaging elements were prepared in a similar way as described in example 1 with the exception that the concentration of the compounds of table 1 was varied (see table 2) and to the coating composition were added one or more of the comonomers hexanedioldimethacrylate (HDDM), pentaerythritoltriacrylate (PETRI) and pentaerythritoltetra-acrylate (PETRA) in a concentration as listed in table 2.

**Table 2**

| Sample | compound of table 1 | | HDDM | PETRI | PETRA |
|---|---|---|---|---|---|
| | nr. | conc. (%) | (%) | (%) | (%) |
| 1 | 14 | 2 | | | 1.5 |
| 2 | 14 | 1.5 | | | 1.5 |
| 3 | 14 | 1.5 | | | 2.0 |
| 4 | 14 | 1.5 | | | 2.5 |
| 5 | 14 | 1.75 | 1.75 | | |
| 6 | 14 | 0.75 | 0.75 | | 2.0 |
| 7 | 15 | 1.5 | | | 2.0 |
| 8 | 18 | 1.5 | | | 2.0 |
| 9 | 16 | 1.5 | | | 2.0 |
| 10 | 17 | 1.5 | | | 2.0 |
| 11 | 23 | 1.5 | | | 2.0 |
| 12 | 23 | 0.225 | 1.275 | | 2.0 |
| 13 | 22 | 2.5 | | | 2.5 |
| 14 | 22 | 1.5 | | | 2.5 |
| 15 | 22 | 1.5 | | | 2.0 |
| 16 | 22 | 2.0 | | | 3.0 |
| 17 | 22 | 1.5 | | 2.0 | |
| 18 | 20 | 1.5 | | | 2.5 |
| 19 | 21 | 1.5 | | | 2.0 |
| 20 | 19 | 1.5 | | | 2.0 |
| 21 | 24 | 1.5 | | | 2.0 |
| 22 | 24 | 1.5 | | 2.0 | |
| 23 | 11 | 2.0 | | | 3.0 |
| 24 | 11 | 1.5 | | | 2.0 |
| 25 | 12 | 1.5 | | | 2.0 |
| 26 | 13 | 1.5 | | | 2.0 |
| 27 | 4 | 2.0 | | | 3.0 |
| 28 | 4 | 1.5 | | | 2.0 |
| 29 | 25 | 1.5 | | | 2.0 |
| 30 | 25 | 0.225 | 1.275 | | 2.0 |
| 31 | 8 | 1.5 | | | 2.0 |
| 32 | 8 | 1.5 | | 2.0 | |
| 33 | 5 | 1.5 | | | 2.0 |
| 34 | 5 | 1.5 | | | 2.5 |
| 35 | 5 | 1.0 | | | 2.0 |
| 36 | 7 | 1.5 | | | 2.0 |
| 37 | 6 | 1.5 | | | 2.0 |
| 38 | 1 | 1.5 | | | 2.0 |
| 39 | 10 | 1.5 | | | 2.0 |
| 40 | 9 | 1.5 | | | 2.0 |

The imaging elements corresponding to samples 1 to 40 were placed in contact with a test target and exposed therethrough to ultraviolet radiation.

Each of the exposed imaging elements was then placed in face-to-face contact with a hydrophilic receiving element prepared as described in example 1.

The contacting elements were conveyed through a roll laminator device at about 186°C and a speed of 0.63m/min. Good copies could be obtained with each of the prepared printing plates using a conventional offset press and commonly employed ink and fountain.

### EXAMPLE 3

An imaging element was prepared as described in example 1 having the composition of sample 15 in example 2 with the only exception that the copolymer of styrene and acrylonitrile used in example 1 was substituted for a co(styrene-vinyltoluene-indene) polymer commercially available from HERCULES under the name HERCULES A100.

The imaging element was placed in contact with a test target and exposed therethrough to ultraviolet radiation.

The exposed imaging element was then placed in face-to-face contact with a hydrophilic receiving element prepared as described in example 1.

The contacting elements were conveyed through a roll laminator device at about 186°C and a speed of 0.63m/min. Next, the elements were peeled apart.

The thus obtained printing plate could be used to print on a conventional offset press using a commonly employed ink and fountain. Good copies were obtained.

### EXAMPLE 4

An aluminium foil having a thickness of 0.15 mm was grained, anodized, and sealed according to the method described in Example 1 of US-A 3,861,917. The centre line average value obtained by the graining was 0.5 µm. An aluminium support having an anodization layer of a weight of 2.7 g per m² is thus obtained.

The imaging element corresponding to sample 14 of example 2 was image wise exposed as described in example 2 and placed in face-to-face contact with the aluminium support described above as the receiving element. The contacting elements were conveyed through a roll laminator device at about 186°C and a speed of 0.63m/min. Next, the elements were peeled apart. A positive image of good quality was obtained on said receiving element.

The thus obtained printing plate could be used to print on a conventional offset press using a commonly employed ink and fountain. Good copies were obtained.

### EXAMPLE 5

The imaging element corresponding to sample 21 of example 2 was image wise exposed as described in example 2 and placed in face-to-face contact with a paper support (IDEAL BLANC BRILLIANT paper) as the receiving element. The contacting elements were conveyed through a roll laminator device at about 186°C and a speed of 1.41 m/min. Next, the elements were peeled apart. A positive image of good quality was obtained on said receiving element.

### EXAMPLE 6

The imaging element corresponding to sample 19 of example 2 was image wise exposed as described in example 2 and placed in face-to-face contact with a paper support having a weight of 80g/m² as the receiving element. The contacting elements were conveyed through a roll laminator device at about 186°C and a speed of 0.36m/min. Next, the elements were peeled apart. A positive image of good quality was obtained on said receiving element.

### EXAMPLE 7

The imaging elements corresponding to samples 19 and 20 of example 2 were image wise exposed as described in example 2 and were each placed in face-to-face contact with a paper support having a weight of 110g/m² and coated on both sides with a polyethylene layer and a layer to improve the adhesion as the receiving element. Each of the contacting elements were conveyed through a roll laminator device at about 186°C and a speed of 1.02m/min for sample 19 and 0.63 m/min for sample 20. Next, the elements were peeled apart. A positive image of good quality was obtained on each of the paper supports.

### EXAMPLE 8

The imaging elements corresponding to samples 18 and 19 of example 2 were image wise exposed as described in example 2 and were each placed in face-to-face contact with a polyethylene terephthatalate support coated with an adhesion layer as the receiving element. Each of the contacting elements were conveyed through a roll laminator device at about 186°C and a speed of 1.41 m/min for sample 18 and 1.02 m/min for sample 19. Next, the elements were peeled apart. A positive image of good quality was obtained on each of receiving elements.

### EXAMPLE 9

The imaging elements corresponding to samples 2 and 16 of example 2 were image wise exposed as described in example 2 and were each placed in face-to-face contact with a polyethylene terephthatalate support coated with an adhesion layer and provided with a vapor deposited aluminium layer as the receiving element . Each of the contacting elements were conveyed through a roll laminator device at about 186°C and a speed of 2.12 m/min. Next, the elements were peeled apart. A positive image of good quality was obtained on each of receiving elements.

### EXAMPLE 10

Imaging elements were prepared as described in example 1 with the difference however that a mixture of two compounds presented in table 1 were used and the concentration of the co(styrene-acrylonitrile) polymer (SAN) was varied. The concentration of the compounds of table 1 and of SAN polymer used for preparing the different imaging elements are shown in table 3.

**Table 3**

| Sample nr. | Compounds of table 1 | | | | SAN (%) |
|---|---|---|---|---|---|
| | nr. | (%) | nr. | (%) | |
| 41 | 18 | 1.5 | 1 | 1.5 | 0.5 |
| 42 | 18 | 1.5 | 5 | 1.5 | 0.5 |
| 43 | 18 | 1.5 | 11 | 1.5 | 0.5 |
| 44 | 18 | 2.0 | 11 | 1.0 | 0.5 |
| 45 | 18 | 2.5 | 11 | 0.5 | 0.5 |
| 46 | 24 | 1.5 | 11 | 1.5 | 0.5 |
| 47 | 24 | 1.5 | 5 | 1.5 | 0.5 |
| 48 | 18 | 1.5 | 11 | 1.5 | - |
| 49 | 18 | 2.0 | 11 | 2.0 | - |
| 50 | 18 | 3.3 | 11 | 1.7 | - |

The imaging elements corresponding to samples 41 to 50 were placed in contact with a test target and exposed therethrough to ultraviolet radiation.

Each of the exposed imaging elements was then placed in face-to-face contact with a hydrophilic receiving element prepared as described in example 1.

The contacting elements were conveyed through a roll laminator device at about 186°C and a speed of 1.54m/min. Good copies could be obtained with each of the thus prepared printing plates using a conventional offset press and commonly employed ink and fountain.

## Claims

1. A method for making an image comprising information-wise exposing to actinic radiation an imaging element comprising a photopolymerizable composition containing a thermoplastic polymer and a photoinitiator, characterized in that said photopolymerizable composition further comprises at least one monomer corresponding to the general formula:
A[-NHCO-X-L₁(-(L₂)ᵤ-OCO-CR₁=CH₂)ₙ]ₘ
wherein n represents an integer from 1 to 3, m equals an integer of 3 to 6 when n equals 1 and 2 to 6 when n equals 2 or 3 and u equals 0 or 1;
A represents an organic group of the following nature being 3 to 6 valent when n equals 1 and being 2 to 6 valent when n equals 2 or 3 :
a) a hydro carbon residue containing 5 to 25 carbon atoms which may be interrupted by one or more ether, ester or amide functions
b) 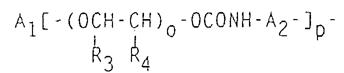 with A₁ representing a linear or branched aliphatic residue that may contain 0 to 3 0-atoms and 2 to 20 C-atoms, an aromatic residue containing 6 to 24 carbon atoms, an aromatic aliphatic residue containing 7 to 28 C-atoms or an cycloaliphatic residue containing 6 to 26 C-atoms, R₃ and R₄ each independently representing a hydrogen or a methyl group, A₂ representing a hydro carbon residue containing 5 to 25 carbon atoms, o represents an integer of 0 to 5 and p represents an integer of 2 to 6 when n equals 2 or 3 and represents an integer of 3 to 6 when n equals 1
c) 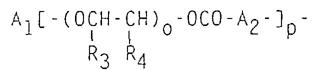 wherein A₁, A₂, R₃, R₄, o and p have the same meaning as defined above
d) 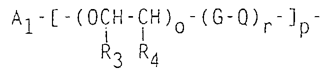 wherein A₁, A₂, R₃, R₄, o and p have the same meaning as defined above,
G represents -O-CO-NH-Y(-COO-)_{q}-
wherein Y represents a divalent (cyclo)aliphatic residue containing 2 to 15 C-atoms and that may contain an ester, ether or urethane function and q represents 0 or 1
Q represents a linear or branched aliphatic hydro carbon residue containing 3 to 15 carbon atoms and which may comprise 1 to 3 oxygen bridges and r equals 0 or 1.
X represents 0 or NR₂,
L₁ represents an aliphatic hydro carbon residue that is at least di-valent and that may comprise 1 to 3 O-atoms,
L₂ represents an alkylene comprising 1 to 6 carbon atoms and which may be branched or linear,
R₁ represents hydrogen or a methyl group,
R₂ represents hydrogen or a lower alkyl group of 1 to 6 C-atoms,

2. A method according to claim 1 wherein A in said general formula corresponds to one of the following aliphatic residue: 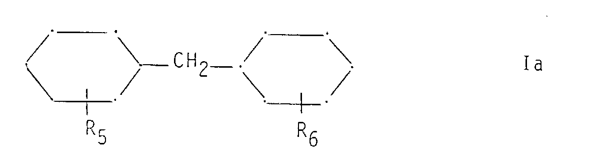 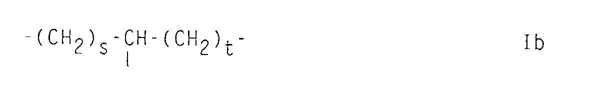 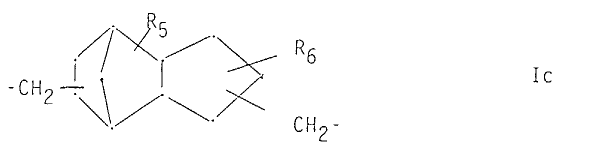 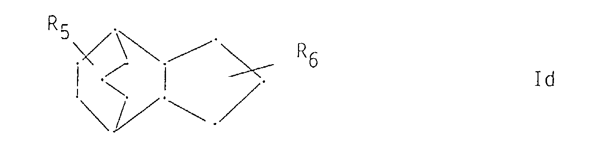 wherein R₅ and R₆ each independently represents hydrogen or a lower alkyl of 1 to 6 C-atoms, s and t independently represent an integer from 1 to 6 and wherein said aliphatic residues Ia, Ic and Id comprise 2 to 6 free valences when n of said general formula equals 2 or 3 and 3 to 6 free valences when n of said general formula equals 1.

3. A method according to claims 1 or 2 wherein after said information-wise exposing of said imaging element the unexposed or insufficiently exposed parts of said photopolymerizable composition are transferred to a receiving material by means of heating while said imaging element and receiving material are in contact with each other.

4. A method according to claim 3 wherein said receiving material is paper, a polyester film support, polyethylene coated paper, an aluminium support, polyvinyl chloride support or polycarbonate support.

5. A method according to claim 3 wherein said receiving material carries a hydrophilic surface thus forming after transfer a lithographic printing plate.

6. A method according to any of claims 3 to 5 wherein said heating is applied to either the imaging element, the receiving element or to both.

7. A method according to any of the above claims wherein said photopolymerizable composition comprises a dye or dye pigment.

8. An imaging element comprising on a support a photo-sensitive layer comprising a photopolymerizable composition, containing a thermoplastic polymer and a photoinitiator characterized in that said photopolymerizable composition comprises at least one monomer as defined in claim 1 or 2.

9. An imaging element according to claims 8 wherein said imaging element also comprises a dye or dye pigment.

## Patentansprüche

1. Verfahren zur Herstellung eines Bildes, bestehend aus der informationmäßigen Belichtung eines bilderzeugenden Elementes, das eine fotopolymerisierbare Zusammensetzung mit einem thermoplastischen Polymeren und einem Fotoinitiator enthält, mit aktinischer Strahlung, dadurch gekennzeichnet, daß die fotopolymerisierbare Zusammensetzung weiterhin wenigstens ein der nachstehenden allgemeinen Formel entsprechendes Monomeres enthält :
A[-NHCO-X-L₁(-(L₂)ᵤ-OCO-CR₁=CH₂)ₙ]ₘ
in der bedeuten :
n eine ganze Zahl von 1 bis 3, m eine ganze Zahl von 3 bis 6 bei n gleich 1 und von 2 bis 6 bei n gleich 2 oder 3, und u gleich 0 oder 1;
A eine organische Gruppe der folgenden Art, die 3- bis 6wertig ist bei n gleich 1 und die 2- bis 6wertig ist bei n gleich 2 oder 3 :
a) ein Kohlenwasserstoffrest mit 5 bis 25 Kohlenstoffatomen, der durch eine oder mehrere Ether-, Ester- oder Amid-Funktionen unterbrochen sein kann,
b) 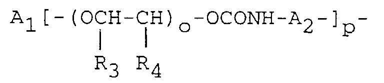 in der bedeuten : A₁ einen geradkettigen oder verzweigten aliphatischen Rest, der 0 bis 3 O-Atome und 2 bis 20 C-Atome enthalten kann, einen aromatischen Rest, der 6 bis 24 Kohlenstoffatome enthält, einen aromatischen aliphatischen Rest, der 7 bis 28 C-Atome enthält, oder einen cycloaliphatischen Rest, der 6 bis 26 C-Atome enthält, R₃ und R₄ unabhängig voneinander je ein Wasserstoffatom oder eine Methylgruppe, A₂ einen Kohlenwasserstoffrest, der 5 bis 25 Kohlenstoffatome enthält, o eine ganze Zahl von 0 bis 5, und p eine ganze Zahl von 2 bis 6 bei n gleich 2 oder 3 und eine ganze Zahl von 3 bis 6 bei n gleich 1
c) 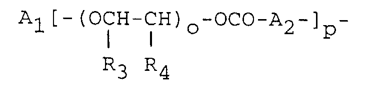 in der A₁, A₂, R₃, R₄, o und p die oben angegebenen Bedeutungen haben
d) 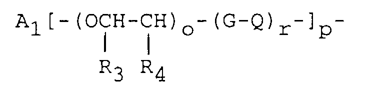 in der A₁, A₂, R₃, R₄, o und p die oben angegebenen Bedeutungen haben,
G -O-CO-NH-Y(-COO-)_{q}- bedeutet
in der Y einen zweiwertigen (cyclo)aliphatischen Rest, der 2 bis 15 C-Atome enthält und eine Ester-, Ether- oder Urethan-Funktion enthalten kann, und q 0 oder 1 bedeutet
Q einen geradkettigen oder verzweigten aliphatischen Kohlenwasserstoffrest, der 3 bis 15 Kohlenstoffatome enthält und 1 bis 3 Sauerstoffbrücken enthalten kann, bedeutet und r gleich 0 oder 1,
X O oder NR₂,
L₁ einen aliphatischen Kohlenwasserstoffrest, der mindestens zweiwertig ist und 1 bis 3 O-Atome enthalten kann,
L₂ ein Alkylen mit 1 bis 6 C-Atomen, das verzweigt oder geradkettig sein kann,
R₁ ein Wasserstoffatom oder eine Methylgruppe,
R₂ ein Wasserstoffatom oder eine Niederalkylgruppe mit 1 bis 6 C-Atomen.

2. Verfahren nach Anspruch 1, dadurch gekennzeichnet, daß in der allgemeinen Formel A einem der nachstehenden aliphatischen Reste entspricht : 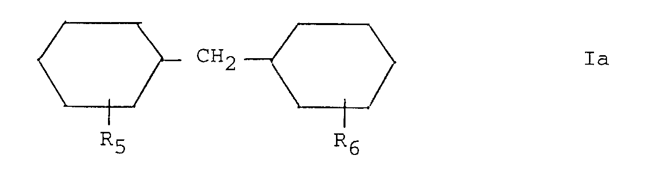 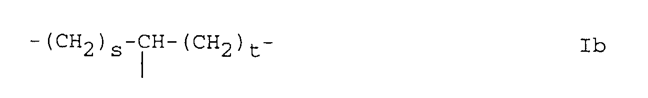 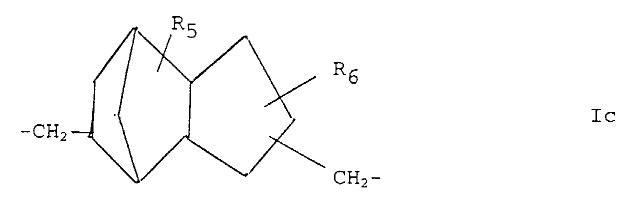 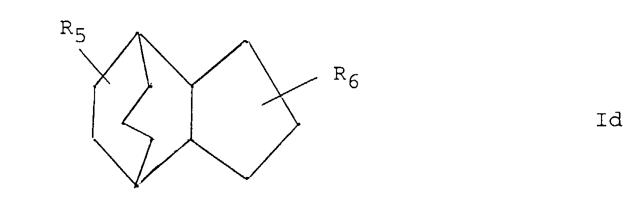 in der R₅ und R₆ unabhängig voneinander je ein Wasserstoffatom oder eine Niederalkylgruppe mit 1 bis 6 C-Atomen, s und t unabhängig voneinander eine ganze Zahl von 1 bis 6 bedeuten, und in der die aliphatischen Reste Ia, Ic und Id 2 bis 6 freie Valenzen enthalten, bei n der allgemeinen Formel gleich 2 oder 3, und 3 bis 6 freie Valenzen enthalten, bei n der allgemeinen Formel gleich 1.

3. Verfahren nach Anspruch 1 oder 2, dadurch gekennzeichnet, daß die unbelichteten oder unzulänglich belichteten Bereiche der fotopolymerisierbaren Zusammensetzung nach der informationmäßigen Belichtung des bilderzeugenden Elementes durch Erhitzung auf ein Empfangsmaterial übertragen werden, während sich das bilderzeugende Element und das Empfangsmaterial berühren.

4. Verfahren nach Anspruch 3, dadurch gekennzeichnet, daß das Empfangsmaterial Papier, ein Polyesterfolienträger, polyethylenbeschichtetes Papier, ein Aluminiumträger, ein Polyvinylchloridträger oder ein Polycarbonatträger ist.

5. Verfahren nach Anspruch 3, dadurch gekennzeichnet, daß das Empfangsmaterial eine hydrophile Oberfläche unterstützt und so nach Übertragung eine lithografische Druckform bildet.

6. Verfahren nach einem der Ansprüche 3 bis 5, dadurch gekennzeichnet, daß entweder das bilderzeugende Element oder das Empfangsmaterial, oder sowohl das bilderzeugende Element wie auch das Empfangsmaterial dieser Erhitzung unterzogen werden.

7. Verfahren nach einem der vorhergehenden Ansprüche, dadurch gekennzeichnet, daß die fotopolymerisierbare Zusammensetzung einen Farbstoff oder ein Farbstoffpigment enthält.

8. Ein bilderzeugendes Element, das auf einem Träger eine strahlungsempfindliche Schicht, die aus einer fotopolymerisierbaren Zusammensetzung mit einem thermoplastischen Polymeren und einem Fotoinitiator besteht, enthält, dadurch gekennzeichnet, daß die fotopolymerisierbare Zusammensetzung wenigstens ein Monomeres nach Anspruch 1 oder 2 enthält.

9. Ein bilderzeugendes Element nach Anspruch 8, dadurch gekennzeichnet, daß das bilderzeugende Element ebenfalls einen Farbstoff oder ein Farbstoffpigment enthält.

## Revendications

1. Un procédé pour faire une image comprenant l'exposition sous forme d'information à un rayonnement actinique d'un élément formateur d'image comprenant une composition photopolymérisable contenant un polymère thermoplastique et un photo-initiateur, caractérisé en ce que la composition photopolymérisable comprend en plus au moins un monomère correspondant à la formule générale:
A[-NHCO-X-L₁(-(L₂)ᵤ-OCO-CR₁=CH₂)ₙ]ₘ
dans laquelle
n représente un nombre entier de 1 à 3, m est égal à un nombre entier de 3 à 6 quand n est égal à 1 et de 2 à 6 quand n est égal à 2 ou 3 et u est égal à 0 ou 1;
A représente un groupe organique du type suivant avec une valence de 3 à 6 quand n est égal à 1 et avec une valence de 2 à 6 quand n est égal à 2 ou 3:
a) un résidu d'hydrocarbure contenant de 5 à 25 atomes de carbone qui peut être interrompu par une ou plusieurs fonctions éther, ester ou amide
b) 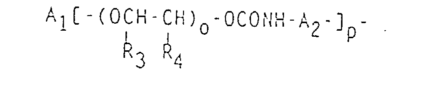 dans laquelle A₁ représente un résidu aliphatique linéaire ou ramifié qui peut contenir de 0 à 3 atomes d'oxygène et de 2 à 20 atomes de carbone, un résidu aromatique contenant de 6 à 24 atomes de carbone, un résidu aromatique aliphatique contenant de 7 à 28 atomes de carbone ou un résidu cycloaliphatique contenant de 6 à 26 atomes de carbone, R₃ et R₄, l'un indépendamment de l'autre, représentent chacun un atome d'hydrogène ou un groupe méthyle, A₂ représente un résidu d'hydrocarbure contenant de 5 à 25 atomes de carbone, o représente un nombre entier de O à 5 et p représente un nombre entier de 2 à 6 quand n est égal à 2 ou 3 et représente un nombre entier de 3 à 6 quand n est égal à 1.
c) 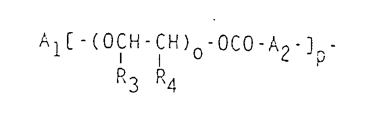 dans laquelle A₁, A₂, R₃, R₄, o et p ont la même signification que celle définie ci-dessus.
d) 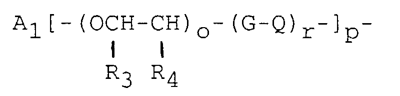 dans laquelle A₁, A₂, R₃, R₄, o et p ont la même signification que celle définie ci-dessus.
G représente -O-CO-NH-Y(-COO-)_{q}-
dans laquelle Y représente un résidu (cyclo)aliphatique bivalent contenant de 2 à 15 atomes de carbone et pouvant contenir une fonction ester, éther ou uréthane et q représente 0 ou 1.
Q représente un résidu d'hydrocarbure aliphatique linéaire ou ramifié contenant de 3 à 15 atomes de carbone et pouvant contenir de 1 à 3 ponts oxygène et r est égal à 0 ou 1.
X représente O ou NR₂,
L₁ représente un résidu d'hydrocarbure aliphatique qui est au moins bivalent et qui peut comprendre de 1 à 3 atomes d'oxygène,
L₂ représente un alkylène comprenant de 1 à 6 atomes de carbone et pouvant être ramifié ou linéaire,
R₁ représente un atome d'hydrogène ou un groupe méthyle,
R₂ représente un atome d'hydrogène ou un groupe alkyle inférieur de 1 à 6 atomes de carbone.

2. Un procédé selon la revendication 1, caractérisé en ce que A dans ladite formule générale correspond à un des résidus aliphatiques suivants: 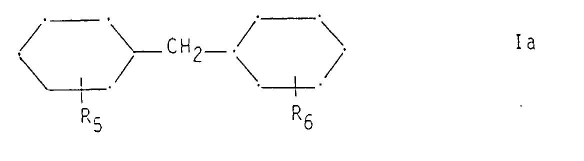 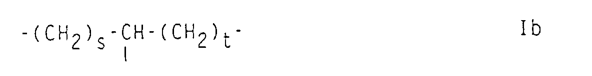 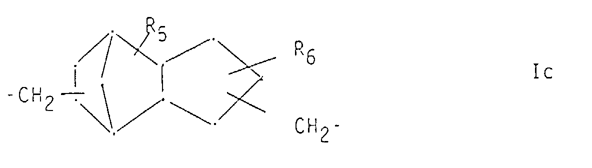 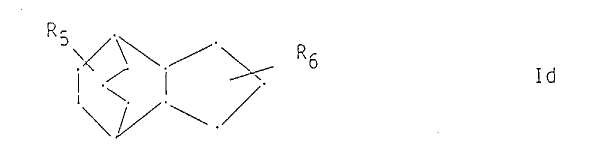 dans lesquels:
R₅ et R₆ , l'un indépendamment de l'autre, représentent chacun un atome d'hydrogène ou un groupe alkyle inférieur en C₁-C₆,
s et t, l'un indépendamment de l'autre, représentent un nombre entier de 1 à 6,
et dans lesquels les résidus aliphatiques Ia, Ic et Id comprennent 2 à 6 valences libres quand n de la formule générale est égal à 2 ou 3, et 3 à 6 valences libres quand n de la formule générale est égale à 1.

3. Un procédé selon les revendications 1 ou 2, caractérisé en ce que, après l'exposition sous forme information de l'élément formateur d'image, les parties non exposées ou insuffisamment exposées de la composition photopolymérisable sont transférées par un échauffement vers un matériau récepteur pendant que l'élément formateur d'image et le matériau récepteur sont en contact l'un avec l'autre.

4. Un procédé selon la revendication 3, caractérisé en ce que le matériau récepteur est du papier, un support de film en polyester, du papier couché au polyéthylène, un support d'aluminium, de poly(chlorure de vinyle) ou de polycarbonate.

5. Un procédé selon la revendication 3, caractérisé en ce que le matériau récepteur possède une surface hydrophile formant ainsi une plaque d'impression lithographique après le transfert.

6. Un procédé selon l'une quelconque des revendications 3 à 5, caractérisé en ce que l'échauffement est appliqué à l'élément formateur d'image, à l'élément récepteur ou aux deux.

7. Un procédé selon l'une quelconque des revendications précédentes, caractérisé en ce que la composition photopolymérisable comprend un colorant ou un pigment de colorant.

8. Un élément formateur d'image comprenant sur un support une couche photosensible comprenant une composition photopolymérisable contenant un polymère thermoplastique et un photo-initiateur, caractérisé en ce que la composition photopolymérisable comprend au moins un monomère comme défini à la revendication 1 ou 2.

9. Un élément formateur d'image selon la revendication 8, caractérisé en ce l'élément formateur d'image comprend également un colorant ou un pigment de colorant.
